# EUROPEAN PATENT SPECIFICATION

(11) **EP 1 959 267 B1**
(45) Date of publication and mention of the grant of the patent: **18.11.2009**
(21) Application number: 07425080.4
(22) Date of filing: 15.02.2007
(51) Int. Cl.: G01R 35/00

(54) **An automatic unit for verifying the calibration of a multimeter**
Automatische Einheit zum Überprüfen der Kalibrierung eines Multimeters
Unité automatique de vérification du calibrage d'un multimètre

(43) Date of publication of application: 20.08.2008
(73) Proprietor: Magneti Marelli S.p.A., Corbetta (MI) (IT)
(72) Inventor: Del Moro, Marco c/o Magneti Marelli S.p.A., corbetta (MI) (IT); Schinco, Franco c/o Magneti Marelli S.p.A., Corbetta (MI) (IT)
(74) Representative: Cerbaro, Elena

(56) References cited:
- GB-A- 1 241 942
- GB-A- 1 405 418
- US-A- 3 409 829
- US-A1- 2002 153 903

## Description

The present invention relates to an automatic unit for verifying the calibration of a multimeter, specifically a hand-held multimeter.

In the field of metrology, it is known to subject measurement instruments to a calibration verification or re-calibration operation when the need arises, e.g. at expiration of the validity date of the previous calibration or in the case in which, during the use of the instruments, facts which may have altered the behaviour of the instruments themselves have occurred, see e.g. GB 1 241 942 A.

The verification of the calibration of an instrument adapted to measure a determined magnitude is normally performed by connecting the instrument itself to an appropriate "reference standard", i.e. to an apparatus capable of simulating different operating conditions, each of which corresponds to a predetermined value of the magnitude being measured. For each of these values, normally called "calibration points", an operator performs a certain number of readings, e.g. ten, of the value actually measured by the instrument and records the result of each reading in a specific table.

In the case of a multimeter, i.e. of a measurer capable of measuring various magnitudes, the calibration verification is repeated for each measurable magnitude, by selecting the magnitude, on a case-by-case basis, on the instrument by means of a specific selector, normally consisting of a rotary switch, and by repeating the measured value readings for the corresponding calibration points for each magnitude.

As the aforesaid steps of selecting the magnitude, reading and copying the measured values are performed in an entirely manual manner by an operator, the calibration verification of a multimeter normally requires a relatively long working time and a high precision by the operator him or herself, specifically during the step of collecting data.

It is the object of the present invention to provide an automatic unit for verifying the calibration of a multimeter, which allows to automatically perform the step of selecting the magnitude to be measured and of reading the measured values so as to speed up the step of collecting data and to eliminate possible errors due to the operator.

According to the present invention, there is made an automatic unit for verifying the calibration of a multimeter according to claim 1 and, preferably, to any of the following claims depending either directly or indirectly on claim 1.

The invention will now be described with reference to the accompanying drawings which illustrate a non-limitative embodiment thereof, in which:
figure 1 is a side view of a preferred embodiment of the unit according to the present invention;
figure 2 is a plan view of the unit in figure 1; and
figures 3 and 4 show corresponding details in figure 1 on a magnified scale.

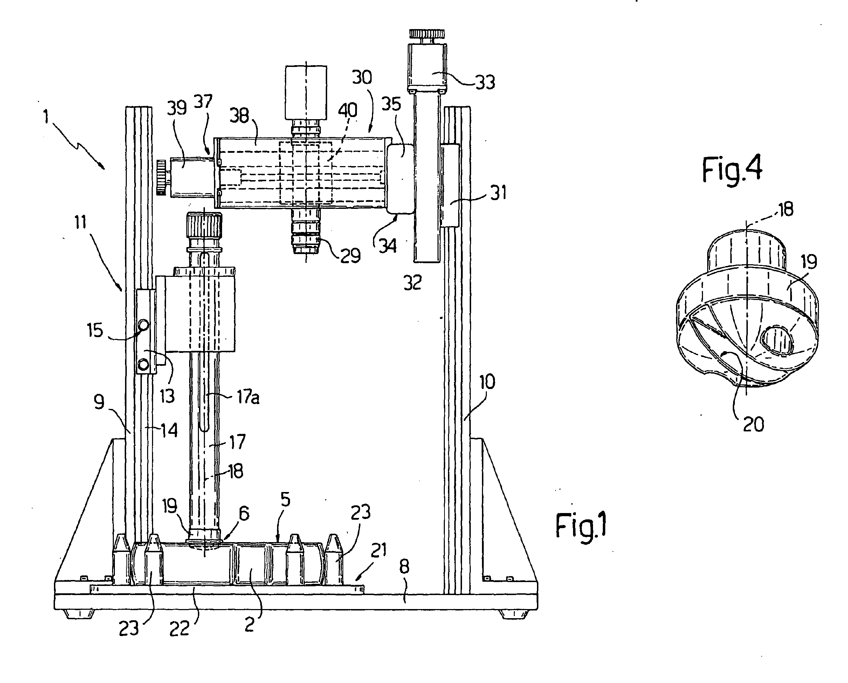

In figure 1, numeral 1 indicates as a whole an automatic unit for verifying the calibration of a multimeter 2 of known type, which comprises an essentially parallelepiped case 3, the front wall 4 of which is defined in part by a display 5 of the digital type and in part by a control panel comprising a rotary switch 6 adapted to allow the manual selection of the magnitude to be measured on a case-by-case basis. Switch 6 comprises, in known manner, a disk which integrally carries a connected control rib 7 provided with a pointer and capable of turning, either clockwise or anticlockwise, about an axis perpendicular to front wall 4 to position the pointer in any one of a plurality of selection positions each corresponding to a corresponding measurable quantity.

Unit 1 comprises a frame 1a comprising, in turn, a flat rectangular plate 8 and two uprights 9 and 10 perpendicular to plate 8 and connected, by means of corresponding brackets, to opposite sides of plate 8.

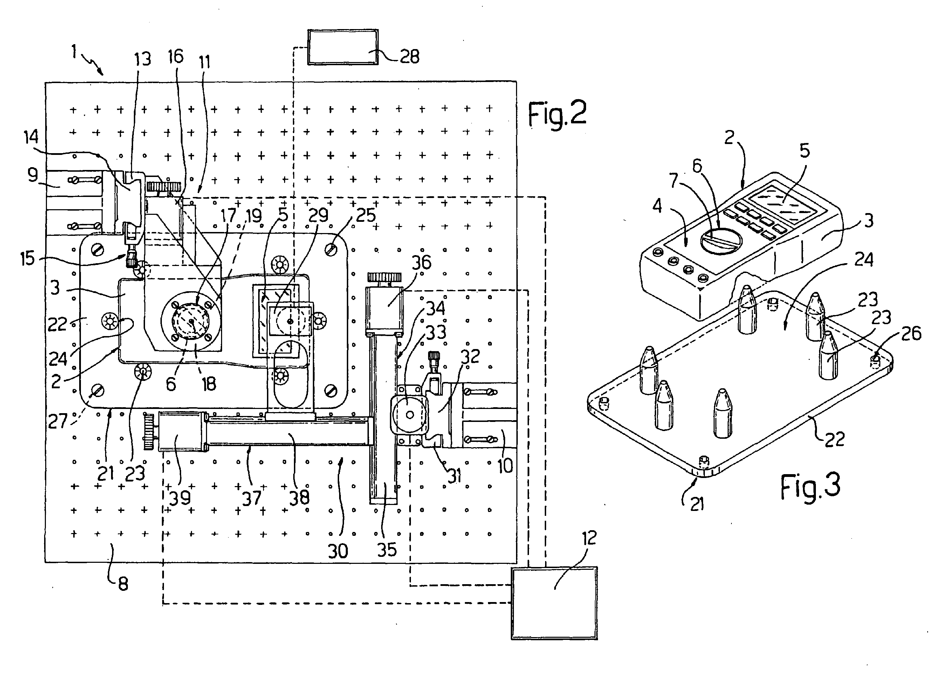

As shown in figures 1 and 2, upright 9 is partially connected to a motorised selector assembly 11, which is connected to a control unit 12 and adapted, in use, to cooperate in the manner explained in greater detail below, with a multimeter 2 to select the magnitude to be measured, in response to an external control from control unit 12.

Specifically, selector assembly 11 comprises a slide 13, which is slidingly mounted along a guide 14 integral with upright 9 and perpendicular to plate 8, presents a manual locking device 15, which allows to lock slide 13 with respect to guide 14, and supports a motor 16 overhangingly protruding from slide 13 towards the centre of plate 8 and connected to control unit 12.

In the example shown, motor 16 is an electrical motor of the stepper type and comprises a stator integral with slide 13 and a rotor turnable about an axis 18 perpendicular to plate 8 and comprising an output shaft 17 protruding from the fixed part towards plate 8.

Shaft 17 integrally carries, on its end facing plate 8, a key 19 defined by a cylindrical body, which is coaxial to axis 18 and presents, on a rounded end surface facing plate 8, two holes for fastening key 19 to shaft 17 by means of screws and a groove 20 perpendicular to axis 18 and adapted to be engaged, in use, by rib 7 of switch 6 to angularly couple shaft 17 to switch 6 itself (figure 4).

As key 19, being integral with shaft 17, may shift only about and along axis 18, axis 18 defines a fixed position on plate 8 in which a multimeter 2 must be arranged, in use, so that corresponding switch 6 is aligned with key 19 along axis 18 and allows the angular coupling of corresponding rib 7 to key 19 following the lowering of key 19 along axis 18.

For this purpose, multimeter 2 is arranged in use in a housing 21, which as shown in figures 1 and 2 and in greater detail in figure 3, comprises a flat rectangular base 22 and a plurality of pins 23 integrally connected to base 22 and distributed on base 22 itself so as to reciprocally define a seat 24 adapted to accommodate multimeter 2 with relative precision. In use, housing 21, with corresponding multimeter 2, is positioned underneath key 19 so that switch 6 is coaxial to axis 18 and is thus removably locked onto base 22 by means of screws 25, each of which engages a corresponding hole 26 on base 22 and a corresponding hole 27 obtained through plate 8.

As the dimensions of seat 24 are determined by the dimensions of the employed multimeter 2, unit 1 is normally provided with a plurality of housings 21, each of which presents a seat 24 having dimensions so as to accommodate a corresponding type of multimeter 2.

As the shape of switch 6 may also differ according to the employed type of multimeter 2, key 19 is removably mounted on the end of shaft 17 and unit 1 is provided with a plurality of appropriately shaped keys 19 for coupling to corresponding switches 6.

As shown in figure 1, the angular coupling of the rotor to shaft 17 is obtained by means of a cotter 17a integral with shaft 17, parallel to axis 18 and engaged in axially sliding manner in a groove obtained on the rotor itself. As will be explained in better detail below, the coupling by means of cotter 17a allows an operator to raise and to lower shaft 17, in use, with respect to plate 8 also after having locked slide 13 on guide 14, making the positioning of a housing 21 on plate 8 or, in the case of analogue multimeters, the replacement of multimeter 2 in its seat 24 easier and faster.

Unit 1 finally comprises an optical device comprising a camera 29, which is supported by upright 10 and faces, in use, the display 5 of a multimeter 2 arranged in corresponding housing 21; and an image processing and recording device 28, which is connected to camera 29 to receive from camera 29 itself the image of display 5 and to obtain, for each calibration point, the numeric values displayed on a case-by-case basis on display 5 itself.

In order to allow the positioning of camera 29 in position facing display 5 for any type of multimeter 2 used, camera 29 is supported by upright 10 by means of the interposition of a motorised actuator assembly 30, which is connected to control unit 12 and is adapted to shift camera 29 along three Cartesian directions following an external command from control unit 21 itself.

As shown in figures 1 and 2, actuator assembly 30 comprises a slide 31 slidingly coupled to a guide 32, which is integral with upright 10 and perpendicular to plate 8 and a motor 33 supported by upright 10 and connected to slide 31 to displace slide 31 itself along guide 32.

In turn, slide 29 integrally carries a connected carriage 34 comprising a guide 35 perpendicular to guide 32 and a motor 36, which is arranged on an end of guide 35 and has the function of displacing a carriage 37 similar to carriage 34 and comprising, in turn, a guide 38 perpendicular to guide 35 and to guide 32, along guide 35 itself.

Carriage 37 further comprises a motor 39 for operating a slide 40, which is slidingly coupled to guide 38, extends from guide 38 towards the middle of plate 8 and integrally carries connected camera 29.

In the example shown, motors 33, 36 and 39 are of the stepper type controlling a screw-nut screw coupling.

In use, the verification of the calibration of a multimeter 2 starts after an operator has locked corresponding housing 21 on plate 8. As previously mentioned, this operation is performed only after having locked slide 13 along guide 14 by means of locking device 15 and after having taken shaft 17 to a raised position so as to leave a free operating space underneath key 19. Housing 21 is fixed to plate 8 so that when multimeter 2 is inserted in seat 24 of housing 21 itself, switch 6 is aligned to key 19 along axis 18.

In this regard, it must be underlined that the locking of housing 21 on plate 8 and the fact that seat 24 is dimensioned so as to precisely contain multimeter 2 prevent, in use, an accidental displacement of multimeter 2, specifically by effect of the vibrations induced by the operation of motors 16, 33, 36 and 39.

Once multimeter 2 is locked in position, the operator manually returns shaft 17 to the lowered position shown in figure 1 so as to obtain the angular coupling of key 19 to switch 6.

At this point, following an external command from control unit 12, motors 33 and/or 36 and/or 39 are operated to respectively displace slide 31 and/or carriage 34 and/or carriage 37 so as to take camera 29 to a position perfectly facing display 5.

It must be said that the aforesaid positioning operation of camera 29 normally occurs only when multimeter 2 the calibration of which is being verified is different from the previously used multimeter. Indeed, in the case in which multimeter 2 is either equal or similar to the previously used one, camera 29 is already in the correct position and the above-described precision positioning is not necessary.

The selection of the magnitude being measured on a case-by-case basis is performed automatically by sending a certain control to motor 16, which corresponds to an appropriate rotation about axis 18 of key 19 and, consequently, of switch 6.

The step of verifying the calibration is obtained by acquiring, by means of camera 29, the values displayed on display 5 for each measurement.

The advantages which may be obtained by means of the use of unit 1 in terms of precision and execution speed of the calibration verification process of a multimeter 2 are clearly apparent from the foregoing description.

Indeed, by appropriately programming control unit 12 it is possible to impart a predetermined sequence of angular advancements corresponding to an automatic selection of the tests being performed to shaft 17, and thus to switch 6.

Furthermore, as the "reading" of the measured values is performed automatically by means of camera 29, the calibration verification may be performed entirely without the direct intervention of an operator on multimeter 2 with the result of a faster execution speed of the verification itself and elimination of possible errors by the operator, specifically in the step of data collecting.

## Claims

1. An automatic unit for verifying the calibration of a multimeter (2), the multimeter (2) being of the type comprising a rotary switch (6) shiftable between a plurality of selection positions corresponding to corresponding measurable magnitudes, and a display (5) for displaying the measured values; the unit (1) comprising a frame (8, 9, 10); a seat (24) adapted to accommodate a multimeter (2) and removably lockable on the frame (8, 9, 10); detector means (28, 29) for reading and recording the values measured on the display (5) during a step of measuring; and control means (12); **characterized in that** the unit further is comprising a motorised shaft (17), which presents an axis (18) and is mounted on the frame (8, 9, 10) to turn in step about said axis (18) and to slide along the axis (18) itself from and to an angular coupling position to the switch (6) of a multimeter (2) arranged, in use, in the seat (24); and **in that** the control means is associated to the shaft (17) to impart subsequent angular advancements about the axis (18) to the shaft (17) so as to displace the switch (6), when angularly coupled to the shaft (17), between subsequent selection positions.

2. A unit according to claim 1, wherein the frame (8, 9, 10) comprises support means (13, 14) of the shaft (17), the support means (13, 14) comprising a first fixed guide (14) parallel to axis (18) and a first slide (13) supporting shaft (17) and mobile along a first guide (14) to shift the shaft (17) along the axis (18) from and to the angular coupling position to the switch (6).

3. A unit according to claim 2, wherein the support means (13, 14) comprise a device for locking the first slide (13) with respect to the first guide (14).

4. A unit according to any of the preceding claims, wherein the detector means (28, 29) comprise a camera (29).

5. A unit according to claim 4, wherein the frame (8, 9, 10) comprises a base (8) on which the seat (24) is fixable; the unit (1) further comprising a motorised actuator assembly (30) interposed between the camera (29) and the frame (8, 9, 10) to displace the camera (29) over the base (8) so as to arrange the camera (29) in use in a position facing the display (5).

6. A unit according to claim 5, wherein the actuator assembly (30) is capable of displacing the camera (29) along three reciprocally perpendicular directions.

7. A unit according to claim 5 or 6, wherein the actuator assembly (30) comprises a second fixed guide (32) parallel to the axis (18); a second slide (31) mobile along the second guide (32); a first carriage (34) mobile along the second guide (32) and comprising a third guide (35) perpendicular to the second guide (32), a second carriage (37) mobile along the third guide (35) and comprising a fourth guide (38) perpendicular to the second (32) and to the third guide (35), and a third slide (40) mobile along the fourth guide (38) and supporting the camera (29).

8. A unit according to claim 7, wherein the second slide (31), the second carriage (37) and the third slide (40) are provided with corresponding actuating motors (33, 36, 39).

9. A unit according to claim 8, wherein the motors (33, 36, 39) are electrical motors of the stepper type.

10. A unit according to any of the preceding claims, and comprising a plurality of selectively usable seats (24), each of which is adapted to accommodate a certain multimeter (2).

## Patentansprüche

1. Eine automatische Einheit zum Überprüfen der Kalibrierung eines Multimeters (2), während das Multimeter (2) von der Art ist, die aufweist: einen Drehschalter (6), der zwischen einer Mehrzahl an Auswahlpositionen schaltbar ist, die entsprechenden messbaren Größen entsprechen, und eine Anzeige (5), um die gemessenen Werte anzuzeigen, während die Einheit (1) umfasst: einen Rahmen (8, 9, 10), einen Sitz (24), der angepasst ist, um ein Multimeter (2) aufzunehmen, und der entfernbar an dem Rahmen (8, 9, 10) verriegelbar ist, Detektormittel (28, 29) zum Lesen und Aufzeichnen der an der Anzeige (5) während eines Messschritts gemessenen Werte sowie Steuermittel (12), **dadurch gekennzeichnet, dass** die Einheit weiterhin umfasst: eine motorisierte Welle (17), die eine Achse (18) darstellt und auf dem Rahmen (8, 9, 10) montiert ist, um in Schritten um die Achse (18) zu drehen und um sich selbst entlang der Achse (18) von und zu einer winkligen Koppelposition zu dem Schalter (6) eines im Betrieb in dem Sitz (24) angeordneten Multimeters (2) zu gleiten, sowie **dadurch, dass** die Steuermittel der Welle (17) zugeordnet sind, um nachfolgende winklige Fortschritte um die Achse (18) an die Welle (17) zu vermitteln, um den Schalter (6) zwischen nachfolgenden Auswahlpositionen zu versetzen, wenn er winklig an die Welle (17) gekoppelt ist.

2. Eine Einheit gemäß Anspruch 1, in der der Rahmen (8, 9, 10) Unterstützungsmittel (13, 14) der Welle (17) umfasst, während die Unterstützungsmittel (13, 14) eine erste feste Führung (14) parallel zur Achse (18) und einen ersten Schlitten (13) aufweisen, der die Welle (17) unterstützt und beweglich entlang einer ersten Führung (14) ist, um die Welle (14) entlang der Achse (18) von und zu der winkligen Koppelposition zu dem Schalter (6) zu versetzen.

3. Eine Einheit gemäß Anspruch 2, in der die Unterstützungsmittel (13, 14) eine Vorrichtung zum Verriegeln des ersten Schlittens (13) in Bezug auf die erste Führung (14) umfassen.

4. Eine Einheit gemäß einem der vorhergehenden Ansprüche, in der die Detektormittel (28, 29) eine Kamera (29) aufweisen.

5. Eine Einheit gemäß Anspruch 4, in der der Rahmen (8, 9, 10) eine Basis (8) umfasst, auf der der Sitz (24) befestigbar ist, während die Einheit (1) weiterhin umfasst: eine motorisierte Aktuatoranordnung (30), die zwischen der Kamera (29) und dem Rahmen (8, 9, 10) angeordnet ist, um die Kamera (29) über der Basis (8) zu verschieben, um die Kamera (29) in Verwendung in einer Position anzuordnen, die der Anzeige (5) gegenüberliegt.

6. Eine Einheit gemäß Anspruch 5, in der die Aktuatoranordnung (30) geeignet ist, die Kamera (29) entlang dreier reziproker rechtwinkliger Richtungen zu verschieben.

7. Eine Einheit gemäß Anspruch 5 oder 6, in der die Aktuatoranordnung (30) umfasst: eine zweite feste Führung (32) parallel zu der Achse (18), einen zweiten Schlitten (31), der entlang der zweiten Führung (32) beweglich ist, einen ersten Wagen (34), der entlang der zweiten Führung (32) bewegbar ist und eine dritte Führung (35) rechtwinklig zu der zweiten Führung (32) aufweist, einen zweiten Wagen (37), der beweglich entlang der dritten Führung (35) ist sowie eine vierte Führung (38) rechtwinklig zu der zweiten (32) und zu der dritten Führung (35) und einen dritten Schlitten (40), der entlang der vierten Führung (38) bewegbar ist und die Kamera (29) unterstützt.

8. Eine Einheit gemäß Anspruch 7, in der der zweite Schlitten (31), der zweite Wagen (37) und der dritte Schlitten (40) mit entsprechenden Aktuatormotoren (33, 36, 39) bereitgestellt sind.

9. Eine Einheit gemäß Anspruch 8, in der die Motoren (33, 36, 39) elektrische Schrittmotoren sind.

10. Eine Einheit gemäß einem der vorhergehenden Ansprüche und umfassend eine Mehrzahl an wahlweise verwendbaren Sitzen (24), von denen jeder angepasst ist, um ein bestimmtes Multimeter (2) aufzunehmen.

## Revendications

1. Unité automatique de vérification du calibrage d'un multimètre (2), le multimètre (2) étant du type comprenant un commutateur rotatif (6) pouvant être déplacé entre une pluralité de positions de sélection correspondant à des magnitudes mesurables correspondantes, et un affichage (5) pour afficher les valeurs mesurées ; l'unité (1) comprenant une armature (8, 9, 10) ; un siège (24) adapté pour accueillir un multimètre (2) et verrouillable de manière amovible sur l'armature (8, 9, 10) ; des moyens de détecteur (28, 29) pour lire et enregistrer les valeurs mesurées sur l'affichage (5) pendant une étape de mesure ; et un moyen de commande (12) ; **caractérisé en ce que** l'unité comprend également un arbre motorisé (17), qui présente un axe (18) et est monté sur l'armature (8, 9, 10) pour tourner par étapes autour dudit axe (18) et pour coulisser le long de l'axe (18) même depuis et jusqu'à une position d'accouplement angulaire jusqu'au commutateur (6) d'un multimètre (2) agencé, pendant l'utilisation, dans le siège (24) ; et **en ce que** le moyen de commande est associé à l'arbre (17) pour transmettre des avancements angulaires successifs autour de l'axe (18) à l'arbre (17) de façon à déplacer le commutateur (6), quand il est couplé angulairement à l'arbre (17), entre les positions de sélection successives.

2. Unité selon la revendication 1, dans laquelle l'armature (8, 9, 10) comprend un moyen de support (13, 14) de l'arbre (17), le moyen de support (13, 14) comprenant un premier guide fixe (14) parallèle à l'axe (18) et un premier coulisseau (13) supportant l'arbre (17) et mobile le long d'un premier guide (14) pour déplacer l'arbre (17) le long de l'axe (18) depuis et jusqu'à la position d'accouplement angulaire au commutateur (6).

3. Unité selon la revendication 2, dans laquelle le moyen de support (13, 14) comprend un dispositif pour verrouiller le premier coulisseau (13) par rapport au premier guide (14).

4. Unité selon l'une quelconque des revendications précédentes, dans laquelle les moyens de détecteur (28, 29) comprennent un appareil photographique (29).

5. Unité selon la revendication 4, dans laquelle l'armature (8, 9, 10) comprend une base (8) sur laquelle le siège (24) peut être fixé ; l'unité (1) comprenant également un ensemble d'actionneur motorisé (30) intercalé entre l'appareil photographique (29) et l'armature (8, 9, 10) pour déplacer l'appareil photographique (29) au-dessus de la base (8) de façon à disposer l'appareil photographique (29) pendant l'utilisation dans une position face à l'affichage (5).

6. Unité selon la revendication 5, dans laquelle l'ensemble d'actionneur (30) peut déplacer l'appareil photographique (29) le long de trois directions réciproquement perpendiculaires.

7. Unité selon la revendication 5 ou 6, dans laquelle l'ensemble d'actionneur (30) comprend un deuxième guide fixe (32) parallèle à l'axe (18) ; un deuxième coulisseau (31) mobile le long du deuxième guide (32) ; un premier chariot (34) mobile le long du deuxième guide (32) et comprenant un troisième guide (35) perpendiculaire au deuxième guide (32), un second chariot (37) mobile le long du troisième guide (35) et comprenant un quatrième guide (38) perpendiculaire au deuxième guide (32) et au troisième guide (35), et un troisième coulisseau (40) mobile le long du quatrième guide (38) et supportant l'appareil photographique (29).

8. Unité selon la revendication 7, dans laquelle le deuxième coulisseau (31), le second chariot (37) et le troisième coulisseau (40) sont dotés de moteurs d'actionnement (33, 36, 39) correspondants.

9. Unité selon la revendication 8, dans laquelle les moteurs (33, 36, 39) sont des moteurs électriques du type pas-à-pas.

10. Unité selon l'une quelconque des revendications précédentes, comprenant une pluralité de sièges (24) utilisables de manière sélective, chacun d'eux étant adapté pour accueillir un certain multimètre (2).
